# EUROPÄISCHE PATENTSCHRIFT

(11) **EP 2 742 106 B1**
(45) Veröffentlichungstag und Bekanntmachung des Hinweises auf die Patenterteilung: **04.09.2019**
(21) Anmeldenummer: 12735844.8
(22) Anmeldetag: 10.07.2012
(51) Int. Cl.: C09J 9/02, C09J 7/10, C09J 7/38, C09J 11/04, C08F 220/18, C09J 133/08, H01L 23/00

(54) **ELEKTRISCH LEITFÄHIGE HAFTKLEBEMASSE UND HAFTKLEBEBAND**
ELECTRICALLY CONDUCTIVE ADHESIVE COMPOUND AND ADHESIVE TAPE
MATIÈRE ADHÉSIVE ÉLECTROCONDUCTRICE ET BANDE ADHÉSIVE

(30) Priorität: 10.08.2011 DE 102011080729
(43) Veröffentlichungstag der Anmeldung: 18.06.2014
(73) Patentinhaber: tesa SE, 22848 Norderstedt (DE)
(72) Erfinder: KEITE-TELGENBÜSCHER, Klaus, 22529 Hamburg (DE)
(86) Internationale Anmeldenummer: PCT/EP2012/063470
(87) Internationale Veröffentlichungsnummer: WO 2013/020767

(56) Entgegenhaltungen:
- WO-A1-2005/057590
- WO-A1-2008/014169
- WO-A2-2011/003948
- US-A- 5 554 678
- Anonymous: "Ceiling temperature", Wikipedia - The free Encyclopedia, 22 October 2017 (2017-10-22), pages 1-2, XP055434663, Retrieved from the Internet: URL:https://en.wikipedia.org/wiki/Ceiling_ temperature [retrieved on 2017-12-13]
- Walter Caseri: "Polymerblends", Römpp online 4.0, 1 August 2010 (2010-08-01), pages 1-2, XP055434802, Retrieved from the Internet: URL:https://roempp.thieme.de/roempp4.0/do/ data/RD-16-03376 [retrieved on 2017-12-13]

## Beschreibung

Die Erfindung betrifft elektrisch leitfähige Haftklebemassen und -bänder mit hervorragender Leitfähigkeit.

Für viele Anwendungen von Kunststoffen in der Elektronik und der Elektrotechnik wird eine elektrische und/oder elektromagnetische und/oder thermische Leitfähigkeit der eingesetzten Komponenten gefordert, auch für die verwendeten Kunststoffteile. Es gibt heute eine Vielzahl von mit leitfähigen Füllstoffen versetzte Kunststoffcompounds, die einen Bereich des spezifischen Durchgangswiderstandes von 10¹⁰ Ω·cm bis 10⁻¹ Ω·cm abdecken. Als elektrisch leitende Füllstoffe werden zum Beispiel Ruß, Kohlefasern, Metallpartikel, Metallfasern oder intrinsisch leitfähige Polymere eingesetzt.

Um einen Isolator wie Kunststoff leitfähig einzustellen, werden über die elektrisch leitfähigen Füllstoffe durchgängige Leitpfade geschaffen, das heißt die leitfähigen Partikel berühren sich im Idealfall. Es ist bekannt, dass sich ein leitendes Netzwerk im Kunststoff am besten mit dem Einbringen von Metall- oder Kohlefasern realisieren lässt. Je länger dabei die Faser ist, desto geringer ist der Gewichtsanteil an Fasern, der für eine bestimmte Leitfähigkeit benötigt wird. Allerdings wird mit zunehmender Faserlänge auch die Verarbeitung problematischer, da die Viskosität des Compounds stark ansteigt. So sind am Markt erhältliche Compounds mit einer Stahlfaserlänge von 10 mm nur bis zu einem maximalen Gewichtsanteil an Fasern von ca. 25 bis 30 % im Spritzgießverfahren verarbeitbar. Mit kürzeren Fasern lassen sich Compounds mit höheren Gewichtsanteilen an Fasern noch im Spritzgießprozess verarbeiten, allerdings bringt dies - im Vergleich zur Langfaser - keine Erniedrigung des spezifischen Durchgangswiderstandes. Ein ähnliches Verhalten gilt für kohlefaser- und metallpartikelgefüllte Thermoplaste.

Ein weiteres Problem ist, dass sich, bedingt durch unterschiedliche Ausdehnungskoeffizienten, das Fasernetz der gefüllten Thermoplaste bei Temperatureinwirkung weitet und die Leitpfade unterbrochen werden.

Bekannt ist es auch, niedrigschmelzende Metalllegierungen in Polymerschmelzen unter Aufschmelzen dieser Legierungen einzuarbeiten, so dass sich Polymer-Metall-Blends ergeben. Solche Blends werden als spritzgegossene oder extrudierte Leiterbahnen in elektronische Bauteile eingebracht.

So offenbart die US 4,533,685 A Polymer-Metall-Blends, die durch gemeinsames Aufschmelzen von Polymer und niedrigschmelzender Metalllegierung hergestellt werden. Als Polymere werden eine Vielzahl Elastomere, Thermoplaste und härtbare Polymere (Duroplaste) beschrieben, ohne eine bevorzugte Auswahl zu treffen. Ein Hinweis auf die Verwendung als Haftklebstoff findet sich in dieser Schrift nicht.

Die Polymer-Metall-Blends werden in dieser Schrift zu Presslingen verarbeitet, die eine Dicke von etwa 6 mm besitzen, oder sie werden spritzgegossen. Es wird weiterhin eine Ausführung dargestellt, bei der aus einer Polyurethanmasse eine Folie gezogen wird, wobei die Metalldomänen stark orientiert werden, so dass lediglich eine anisotrope Leitfähigkeit resultiert.

Nachteilig an diesen Systemen ist die Notwendigkeit der Ausbildung eines Blends mit einer kontinuierlichen metallischen Phase, um hohe Leitfähigkeit zu erreichen. Dies wird erst bei einem Metallanteil von 50 Vol-% erreicht. Darunter werden zwar geringere Leitfähigkeiten erreicht, jedoch ist hier die zufällige Ausbildung von Leitpfaden notwendig, so dass das System keinen nennenswerten Vorteil gegenüber partikelgefüllten Systemen bietet.

Liegt eine kontinuierliche Metallphase vor, so nimmt das Material im Wesentlichen auch die mechanischen Eigenschaften des Metalls an, was zum Beispiel eine geringe Elastizität und Verformbarkeit bedeutet. Bei Belastung brechen die Metallstrukturen leicht und die Leitfähigkeit sinkt. Solche Strukturen sind daher nicht sinnvoll als Haftklebemasse zu verwenden.

Der Zusatz von metallischen Füllstoffen (Pulver, Fasern oder Plättchen) zur Erhöhung der Leitfähigkeit wird allgemein beschrieben, ohne jedoch eine konkrete Auswahl zu treffen.

Die US 4,882,227 A beschreibt eine elektrisch leitfähige Harzmischung, in die eine niedrigschmelzende Metalllegierung sowie leitfähige Fasern eingearbeitet sind. Das Harz wird allerdings oberflächlich auf die Faser-Metall-Mischung beschichtet und dann in Pellets geformt. Somit ist die Oberfläche der Mischung in wesentlichen Teilen nicht leitfähig. Es wird keine isotrop leitfähige Blendstruktur erzeugt.

Die dort verwendeten Polymere sind typische technische Thermoplaste, die der Fachmann in diesem Zusammenhang nicht zur Herstellung von Haftklebemassen in Erwägung ziehen würde.

Darüber hinaus ist offenbart, dass in dem beschriebenen Harz der Anteil an leitfähigen Fasern 30 Gew.-% nicht übersteigen darf, da ansonsten die Fließfähigkeit und damit die Verarbeitbarkeit des Harzes stark degradiert würden. Dies schränkt die erreichbare Leitfähigkeit ein.

Erst in einem zweiten Schritt werden die erzeugten Pellets als Masterbatch in eine Polymerschmelze aus einem der o.g. Polymere eingebracht und dispergiert. Durch die weitere "Verdünnung" der leitfähigen Komponenten sinkt die Gesamtleitfähigkeit, so dass die Anwendung im Bereich des EMI-Shielding (Abschirmung elektromagnetischer Interferenz) gesehen wird, bei dem eine Leitfähigkeit im Bereich von 10⁻² bis 10² S/cm ausreicht.

Die US 5,554,678 A beschreibt ebenfalls eine für Shielding-Zwecke ausreichend leitfähige Komposition, welche Metallfasern, eine niedrigschmelzende Metalllegierung sowie zusätzlich Kohlenstofffasern enthält. Auch hier werden als Polymer-Basis typische technische Thermoplaste genannt, die der Fachmann nicht zur Herstellung von Haftlebemassen in Erwägung ziehen würde. Wiederum wird zunächst ein Masterbatch hergestellt und pelletiert. Eine Weiterverarbeitung erfolgt bevorzugt im Spritzgießen. Es wird auch die Verarbeitung durch Spritzguss in Sheets mit anschließender Formgebung beschrieben. Aus dieser Art der Weiterverarbeitung ergibt sich, dass die genannten Acrylate nicht als Haftklebemassen verwendet werden, sondern als Formmassen auf Acrylatbasis eingesetzt werden.

EP 942 436 B1 offenbart eine elektrisch leitende Harzverbindung, enthaltend ein zinkbasiertes Metallpulver, ein niedrig schmelzendes Metall (ausgewählt aus der Gruppe bestehend aus Zinn und aus Zinn-Metalllegierungen, die zum Zeitpunkt eines Formungsvorganges geschmolzen werden), und ein synthetisches Harzmaterial. Im Vergleich zu den oben beschriebenen Schriften werden hier die Metallfasern durch Partikel ersetzt. Dies wird bevorzugt, um die Fließeigenschaften und damit die Verarbeitbarkeit im Spritzgießen zu verbessern. Auch hier wird die Harzverbindung zunächst pelletiert, um dann im Spritzgießverfahren weiterverarbeitet zu werden. Gemäß der Materialauswahl und der Verarbeitungstechnologie würde der Fachmann diese Schrift nicht zur Herstellung von elektrisch leitfähigen Haftklebemassen heranziehen.

In der EP 1 695 358 B1 wird ein Metall-Kunststoff-Hybrid vorgeschlagen, das einen Thermoplasten, eine im Bereich zwischen 100 °C und 400 °C schmelzende bleifreie Metallverbindung in einer Menge von 20 bis 50 Gew.-% und Kupferfasern in einer Menge von 30 bis 70 Gew.-% umfasst.

Als Thermoplasten-Komponente enthält das Metall/Kunststoff-Hybrid Massenkunststoffe wie ein Polystyrol (PS) oder ein Polypropylen (PP), technische Thermoplaste wie Polyamid (PA) oder Polybutylenterephthalat (PBT) oder Hochtemperaturthermoplasten. Auch Blends oder thermoplastische Elastomere werden genannt. Ein Hinweis auf Haftklebstoffe wird nicht gegeben. Die Hybride werden zum Herstellen von Formkörpern im Spritzgießverfahren verwendet.

Auch elektrisch leitfähige Haftklebstoffe sind grundsätzlich bekannt.

So wird bei isotrop elektrisch leitfähigen Haftklebemassen deren Leitfähigkeit durch Füllung mit einem elektrisch leitfähigen Füllstoff bewirkt. Dabei ist der Füllgrad so zu wählen, dass eine Perkolation des Füllstoffs auftritt, also durch geringen Abstand zwischen den Füllstoffpartikeln oder direktem Kontakt Leitpfade für den elektrischen Strom entstehen. Ein Beispiel für dieses Prinzip beschreibt die US 1990-472950 A.

Die WO 2008 014169 A beschreibt eine elektrisch leitfähige Klebmasse auf Basis einer Acrylathaftklebemasse. Zur Erzielung der Leitfähigkeit werden Füllstoffe mit einer niedrigen Dichte eingesetzt, die mit einer Metallschicht überzogen sind. Polymer-Metall-Blends werden nicht beschrieben.

Unterstützt wird die Leitfähigkeit in der Fläche oft durch eine Schicht eines leitfähigen Materials (zum Beispiel Metallfolie oder -gitter, metallisierte Folie oder Vlies). Derartige Produkte zeichnen sich allerdings nachteilig durch eine geringe Anschmiegsamkeit an raue Untergründe aus, da sie durch die flächige Einlage an Flexibilität verlieren.

Weitere isotrop leitfähige Haftklebemassen basieren auf haftklebrigen Gelen (zum Beispiel EP 561 854 B1). Diese sind aber für technische Anwendungen in der Regel zu wenig kohäsiv und werden daher für die temporäre Verklebung von Elektroden auf Haut verwendet.

Bei anisotrop leitfähigen Klebefolien wird die Leitfähigkeit in der Fläche durch verschiedene Maßnahmen verhindert, so dass in der Regel nur eine Leitfähigkeit senkrecht zur Fläche verbleibt. Ein solches Prinzip zeigt beispielsweise die US 1992-874553 A. Weit verbreitet ist die Füllung des Klebstoffs mit einem Füllstoff, dessen Teilchendurchmesser größer ist als die Schichtdicke der Folie, wobei der Füllgrad unterhalb der Perkolationsschwelle bleibt.

Eine weitere Klasse an Haftklebefolien ist nur in der Fläche leitfähig, nicht aber senkrecht zur Fläche. Dies wird durch das Einlegen einer leitfähigen Schicht zwischen Schichten aus nicht leitfähigem Klebstoff erreicht.

Die Schrift WO 2011/003948 A beschreibt eine elektrisch leitfähige Klebstoffzusammensetzung, die einen Flüssigkleber darstellt.

Insbesondere bei isotrop leitfähigen Haftklebemassen ist das Erreichen einer ausreichend hohen Leitfähigkeit bei gleichzeitig hoher Verklebungsleistung schwierig, da mit zunehmendem Füllgrad die zur Verfügung stehende aktive Verklebungsfläche sinkt. Daher ist es ein gängiges Konzept, die notwendigen Füllgrad durch geschickte Auswahl eines oder einer Kombination von Füllstoffen zu minimieren. Hierzu werden zum Beispiel hochleitfähige Metalle wie Silber, Kupfer oder Gold sowie in ihrem Aspektverhältnis variierte Formen von elektrisch leitfähigen Füllstoffen, wie zum Beispiel Fasern oder Plättchen (auch im Mikrometer- oder Nanometermaßstab) eingesetzt. Zu nennen sind hier insbesondere Silberfasern, Kupferfasern, silberbeschichtete Micaplättchen oder Schichtsilikate sowie Kohlenstoffnanoröhrchen und Graphen.

Nachteilig an den bekannten füllstoffhaltigen elektrisch leitfähigen Haftklebemassen ist zudem, dass die gebildeten Leitpfade durch thermisch oder mechanisch ausgelöste Dehnung des Systems leicht durchbrochen werden können, so dass die Leitfähigkeit sinkt.

Aufgabe der Erfindung war es nun, eine verbesserte, im Wesentlichen isotrop leitfähige, Haftklebemasse zur Verfügung zu stellen, bei der hohe Klebkraft mit hoher elektrischer Leitfähigkeit vereint ist. Weiterhin soll ein entsprechendes Haftklebeband zur Verfügung gestellt werden. Das Klebeband soll zudem flexibel sein und keinen Leitfähigkeitsabfall durch Dehnung zeigen.

Die Lösung dieser Aufgabe wurde gefunden durch eine Haftklebemassenzusammensetzung, die zumindest einen Polymer-Metall-Blend und zumindest einen - insbesondere faserförmigen - elektrisch leitfähigen Füllstoff umfasst. Erfindungsgemäß umfasst der Polymer-Metall-Blend seinerseits zumindest eine Haftklebemasse, die insbesondere eine solche sein kann, wie sie aus dem Stand der Technik an sich bekannt ist, sowie zumindest eine im Temperaturbereich von 50 °C bis 400 °C schmelzende Metallkomponente, nämlich eine eutektische Metalllegierung enthaltend Zink, Zinn und/oder Wismut. Der Füllstoff liegt dabei als gebundenes Fasernetzwerk mit der Metallkomponente vor.

"Im Temperaturbereich von 50 °C bis 400 °C schmelzende Metallkomponente" bedeutet, dass für Metallkomponenten mit einem Schmelzpunkt der Schmelzpunkt in dem angegebenen Bereich liegt, für Metallkomponenten mit einem Schmelzbereich die Untergrenze dieses Schmelzbereichs größer oder gleich 50 °C ist und die Obergrenze dieses Schmelzbereichs kleiner oder gleich 400 °C ist. Die Angaben zu Schmelzpunkten und Grenzen des Schmelzbereichs der Metallkomponenten beziehen sich auf die dynamische Messung nach DIN 51004 mit einer Heizrate von 10 °C/min.

"Gebundenes Fasernetzwerk" bedeutet insbesondere, dass die Fasern durch das Metall miteinander verbunden vorliegen und nicht nur sich mechanisch berührend aneinander liegen. Insbesondere können einzelne Teilabschnitte der Fasern in unterschiedliche Bereiche der metallischen Phase eingebunden, z.B. eingeschmolzen, sein, so dass durchgängige Leitungspfade vorliegen.

Überraschend konnten so Haftklebemassen hergestellt werden, die bei niedrigem Füllgrad hohe Leitfähigkeit und hohe Verklebungsfestigkeit vereinen. Durch die hohe Affinität der Metallblends zu dem Füllstoff und dessen faserförmige Geometrie wird überraschend bereits bei geringeren Füllgraden als bei reiner Partikelfüllung eine für viele Anwendungen ausreichende Leitfähigkeit erreicht. Daher fallen die haftklebrigen Eigenschaften einer erfindungsgemäßen Haftklebemasse aufgrund der erhöhten Kontaktfläche zum Verklebungssubstrat verbessert aus.

Ein Vorteil der Erfindung ist, dass die Fasern durch die enthaltene Metallverbindung miteinander kontaktiert werden und somit bereits bei vergleichsweise niedrigen Füllgraden hohe Leitfähigkeiten erreicht werden. Andererseits werden durch den oben beschriebenen synergistischen Effekt auch bei hohen Leitfähigkeiten hohe Verklebungsfestigkeiten erreicht.

Haftklebemassen (PSA; englisch: "pressure sensitive adhesives") sind insbesondere solche polymeren Massen, die - gegebenenfalls durch geeignete Additivierung mit weiteren Komponenten, wie beispielsweise Klebharzen - bei der Anwendungstemperatur (sofern nicht anders definiert, bei Raumtemperatur) dauerhaft klebrig und - abgesehen von eventuell auftretenden Alterungsprozessen - permanent klebfähig sind und an einer Vielzahl von Oberflächen bei Kontakt anhaften, insbesondere sofort anhaften (einen sogenannten "Tack" [Klebrigkeit oder Anfassklebrigkeit] aufweisen). Sie sind in der Lage, bereits bei der Anwendungstemperatur ohne eine Aktivierung durch Lösemittel oder durch Wärme - üblicherweise aber durch den Einfluss eines mehr oder weniger hohen Druckes - ein zu verklebenden Substrat hinreichend zu benetzen, damit sich zwischen der Masse und dem Substrat für die Haftung hinreichende Wechselwirkungen ausbilden können.

Durch geeignete kohäsionssteigernde Maßnahmen, wie beispielsweise Vernetzungreaktionen (Ausbildung brückenbildender Verknüpfungen zwischen den Makromolekülen), kann der Temperaturbereich, in dem eine Polymermasse haftklebrige Eigenschaften aufweist, vergrößert und/oder verschoben werden. Der Anwendungsbereich der Haftklebemassen kann somit durch eine Einstellung zwischen Fließfähigkeit und Kohäsion der Masse optimiert werden.

Haftklebemassen können grundsätzlich auf Grundlage von Polymeren unterschiedlicher chemischer Natur hergestellt werden. Die haftklebenden Eigenschaften werden unter anderem durch die Art und die Mengenverhältnisse der eingesetzten Monomere bei der Polymerisation der der Haftklebemasse zugrunde liegenden Polymere, deren mittlere Molmasse und Molmassenverteilung sowie durch Art und Menge der Zusatzstoffe der Haftklebemasse, wie Klebharze, Weichmacher und dergleichen, beeinflusst.

Als Haftklebemasse können vorliegend prinzipiell alle dem Fachmann bekannten Haftklebemassen eingesetzt werden.

Als Haftklebemassen werden erfindungsgemäß insbesondere solche auf der Basis von Naturkautschuken und/oder Synthesekautschuken, solche auf Basis von Silikonen und/oder solche auf der Basis von Acrylaten und/oder Methacrylaten gewählt.

"Auf der Basis von" bedeutet vorliegend, dass die Eigenschaften der Haftklebemasse zumindest stark von den grundlegenden Eigenschaften dieses Polymers (dem so genannten "Basispolymer") bestimmt werden. Insbesondere kann dies bedeuten, dass der Anteil des Basispolymers an der Gesamtmasse der polymeren Phase mehr als 50 Gew.-% beträgt. Die Haftklebemasse kann weitere Polymere und/oder Oligomere enthalten. Insbesondere die Verwendung von klebrigmachenden Harzen (Klebharzen) kann vorteilhaft sein, um die Eigenschaften der Haftklebemasse einzustellen. Der Haftklebemasse können modifizierende Hilfs- oder Zusatzstoffe (zum Beispiel Weichmacher, Alterungsschutzmittel, Füllstoffe, Schäumungsmittel und dergleichen) zugemischt sein.

Als besonders empfehlenswert hat es sich die Verwendung von Polyacrylathaftklebemassen als Haftklebemasse für den Polymer-Metall-Blend herausgestellt, also solcher Haftklebemassen auf Basis von Monomeren aus der Gruppe umfasssend Acrylsäure, Methacrylsäure, Acrylsäureester, Methacrylsäureester, und weitere (co-)polymerisierbare Acrylsäureester und Methacrylsäureester (im Folgenden gemeinsam als "Acrylmonomere" bezeichnet).

Erfindungsgemäß geeignete Polyacrylathaftklebemassen können Acrylat-Reinsysteme sein, also ausschließlich auf Acrylmonomeren basieren, aber auch weitere einpolymerisierte Comonomerbausteine beinhalten. Die entsprechenden Comonomere, auf die diese Bausteine zurückzuführen sind, können insbesondere Vinylmonomere mit zumindest einer copolymerisierbaren Doppelbindung sein. Geeignete Comonomere sind beispielweise Maleinsäureanhydrid, Styrol, Styrol-Verbindungen, Vinylacetat, Acrylamide, mit Doppelbindung funktionalisierte Photoinitiatoren.

Die Comonomere können genutzt werden, um die Eigenschaften der Haftklebemasse einzustellen. Ein das Verhalten der Haftklebemassen beeinflussender Faktor ist die Glasübergangstemperatur des Polymers, die durch die Monomerzusammensetzung gesteuert werden kann. So können die Comonomere zur Steuerung der Glasübergangstemperatur des Copolymers, das die Basis für die Haftklebemasse darstellt, gezielt eingesetzt werden. Weiterhin können mittels der Comonomere auch funktionelle Gruppen eingeführt werden, die ebenfalls zur Steuerung der Eigenschaften der Haftklebemasse (zum Beispiel durch Einführung polarer Gruppen) und/oder die beispielweise für eine Vernetzungsreaktion oder eine Härtungsreaktion genutzt werden können.

Insbesondere vorteilhaft weisen die Polyacrylathaftklebemassen zumindest teilweise Säuregruppen auf, die mit den ggf. entsprechend modifizierten Acrylmonomeren und/oder mit säuregruppenhaltigen Comonomere (insbesondere Vinylmonomeren) in das Polymer eingebracht wurden. Insbesondere durch Säuregruppen lassen sich die Eigenschaften der Haftklebemasse auf besonders einfache Weise innerhalb eines großen Bereiches gezielt steuern, insbesondere etwa deren kohäsive und/oder adhäsive Eigenschaften. Dies wird durch die Möglichkeit, die Eigenschaften durch Verwendung weiterer geeigneter Comonomere zusätzlich anpassen zu können, weiterhin verbessert.

Polyacrylathaftklebemassen bieten den Vorteil, dass sie besonders einfach in der Schmelze mit der Metalllegierung und dem Füllstoff abgemischt und anschließend aus der Schmelze aufgetragen werden können, so dass bei Verwendung dieser Systeme die weitere Verarbeitung stark vereinfacht wird. Ein weiterer Vorteil von Polyacrylathaftklebemassen ist, dass diese besonders alterungsstabil sind und somit Elektronentransportprozessen langzeitig standzuhalten vermögen. Insbesondere haben sich dabei Polymere als vorteilhaft herausgestellt, die zusätzlich Comonomere mit Säuregruppen aufweisen, da diese die Leitfähigkeit unterstützen.

Erfindungsgemäß sehr vorteilhaft werden Polyacrylate als Basispolymere der Haftklebemasse gewählt, wie sie etwa durch radikalische Polymerisation erhältlich sind, und die zumindest teilweise auf mindestens einem Acrylmonomer der allgemeinen Formel CH₂=C(R¹)(COOR²) basieren, wobei R¹ H oder ein CH₃-Rest ist und R² gewählt ist aus der Gruppe umfassend Wasserstoff und die gesättigten, unverzweigten oder verzweigten, substituierten oder unsubstituierten C₁- bis C₃₀-Alkylreste (vorteilhafterweise der C₂- bis C₂₀-Alkylreste, bevorzugt der C₄- bis C₁₄-Alkylreste, besonders bevorzugt der C₄- bis C₉-Alkylreste).

Spezifische Beispiele, ohne sich durch diese Aufzählung einschränken zu wollen, sind Methylacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat und deren verzweigte Isomere, beispielsweise Isobutylacrylat, 2-Ethylhexylacrylat, 2-Ethylhexylmethacrylat, Isooctylacrylat, Isooctylmethacrylat, Cyclohexylmethacrylat, Isobornylacrylat, Isobornylmethacrylat und 3,5-Dimethyladamantylacrylat.

Als erfindungsgemäß hervorragend verwendbare Haftklebemassen haben sich auch solche auf Basis von Synthesekautschuken herausgestellt. Dazu gehören vor allem Haftklebemassen auf der Basis von Polyisobutylen (PIB), wie sie beispielsweise in der WO 2007/087281 A1 oder in der DE 10 2008 060 113 A1 beschrieben sind, solche Haftklebemassen auf Basis von Blockcopolymeren enthaltend einerseits Polymerblöcke überwiegend gebildet von Vinylaromaten (A-Blöcke) und andererseits Polymerblöcke überwiegend gebildet durch Polymerisation von 1,3-Dienen (B-Blöcke), und solche Haftklebemassen auf Basis teilkristalliner Polyolefine, wie sie beispielsweise in der DE 10 2008 047 964 A1 beschrieben sind. Die dort aufgeführten Haftklebemassen zeichnen sich durch besonders geringe Wasserdampfpermeation und geringen Wassergehalt aus, so dass Korrosionsprozesse innerhalb der elektrisch leitfähigen Haftklebemasse und an der kontaktierten Grenzfläche vermindert werden.

Übergreifend sind Haftklebemassen mit einer Wasserdampfpermeation von weniger als 50 g/m²d (ermittelt nach ASTM F-1249 bei 38 °C und 90 % relativer Feuchte bei einer Schichtdicke von 50 µm) zur Verminderung von korrosionsbedingten Leitfähigkeitsverlusten bevorzugt.

Weiterhin bevorzugt sind Haftklebemassen mit einem Wassergehalt von weniger als 5000 ppm, insbesondere weniger als 1000 ppm, ermittelt nach 72 h Konditionierung bei 23 °C und 50 % relativer Feuchte mittels Karl-Fischer-Titration (Ausheiztemperatur 150 °C).

Als niedrig schmelzende Metallkomponente werden niedrig schmelzende eutektische Metalllegierungen eingesetzt, enthaltend Zink, Zinn oder und/Wismut. Die Metallkomponente umfasst im Wesentlichen eines oder mehrere Metalle, kann aber beliebige Zusätze, insbesondere auch nichtmetallische Zusätze und Additive enthalten.

Unter einer niedrig schmelzenden Metalllegierung wird eine metallische Verbindung verstanden, deren Schmelzpunkt bzw. Schmelzbereich zwischen 50 °C und 400 °C, vorzugsweise zwischen 100 °C und 300 °C liegt. Sowohl niedrig schmelzende Metalllegierungen mit einem Schmelzbereich als auch solche mit einem Schmelzpunkt können erfindungsgemäß eingesetzt werden.

Ein Merkmal der niedrig schmelzenden Metalllegierung mit Schmelzpunkt ist ein unmittelbarer und drastischer Viskositätsabfall auf < 50 mPa·s beim Überschreiten des Schmelzpunktes. Diese extrem niedrige, fast wasserähnliche Viskosität trägt im Klebeband entscheidend zum Auffließen der Metalllegierung auf das zu kontaktierende Substrat bei thermischer Beaufschlagung des Haftklebebandes mit einer Temperatur oberhalb der Schmelztemperatur der Metalllegierung bei. Bei einer niedrig schmelzenden Metalllegierung (Lotverbindung) mit einem Schmelzbereich fällt die Viskosität im Schmelzbereich kontinuierlich ab und erreicht erst nach Überschreiten des Schmelzbereichs einen Wert < 50 mPa·s. Erfindungsgemäß können sowohl niedrig schmelzende Metallverbindungen mit einem Schmelzpunkt als auch solche mit einem Schmelzbereich eingesetzt werden. Bevorzugt werden Metalllegierungen mit einem Schmelzbereich, da sich durch den breiteren Temperaturbereich der Erstarrung ein zum Klebstoff ähnlicheres rheologisches Verhalten ergibt, so dass die Extrusion von dünnen Folien, insbesondere deren Verstreckung im Extrusionsprozess erleichtert wird. Solche Metalllegierungen mit einem breiten Schmelzbereich finden sich in der Regel im über- oder untereutektischen Mischungsbereich der Legierung.

Erfindungsgemäß werden eutektische Legierungen eingesetzt, da hierbei Entmischungserscheinungen geringer ausfallen und weniger Anhaftungen an den Oberflächen der Compoundier- und Ausformungswerkzeuge auftreten.

Bevorzugt werden niedrig schmelzende Metallverbindungen eingesetzt, die frei von Schwermetall, insbesondere solche, die bleifrei sind, also unter toxikologischen Gesichtspunkten unbedenklich sind. Die erfindungsgemäß eingesetzten niedrig schmelzenden Metallverbindungen enthalten zumindest auch Zinn, Zink und/oder Wismut.

Je nach Anforderung können die Anteile an niedrig schmelzender Metalllegierung und elektrisch leitfähigen Füllstoffen in einem weiten Bereich variiert werden, allgemein in der Summe zwischen 10 bis 99 Gew.-%, insbesondere zwischen 30 und 95 Gew.-% und zwischen 40 und 90 Gew.-%. Zur Erreichung der höchsten Leitfähigkeit hat sich gezeigt, daß der Anteil der niedrig schmelzenden Metalllegierung zwischen 20 und 60 Gew.-%, vorteilhafterweise zwischen 25 und 40 Gew.-% und insbesondere bevorzugt zwischen 27 und 35 Gew.-% liegen sollte. Der Anteil an leitfähigen Füllstoffe(n) beträgt bevorzugt zwischen 20 und 80 Gew.-%, insbesondere bevorzugt zwischen 30 und 70 Gew.-% und insbesondere bevorzugt zwischen 35 und 65 Gew.-%.

Damit können spezifische Durchgangswiderstände von <10⁻³ Ω·cm erreicht werden. Ebenso gut können hohe thermische Leitfähigkeiten > 0,5 W/mK erreicht werden. Die Anforderungen an die Leitfähigkeiten (elektrisch/thermisch) richten sich nach dem Einsatzgebiet des Klebefilms und können in weiten Grenzen variieren. Die Angabe der Leitfähigkeiten soll die Erfindung jedoch in keiner Weise einschränken.

Als elektrisch leitender Füllstoff können alle üblichen und geeigneten Materialien verwendet werden, etwa Aluminium, Kupfer, Silber, Gold, Nickel, Mu-Metall, Alnico, Permalloy, Ferrit, Kohlenstoff-Nanoröhren, Graphen und dergleichen. Günstigerweise weist der elektrisch leitende Füllstoff dabei eine elektrische Leitfähigkeit von mehr als 20 MS/m auf (entsprechend einem spezifischen Widerstand von weniger als 50 mΩ·mm²/m), insbesondere von mehr als 40 MS/m (entsprechend einem spezifischen Widerstand von weniger als 25 mΩ·mm²/m), jeweils bestimmt für 300 K.

Bevorzugt werden Kupfer und Nickel eingesetzt, welche auch lediglich als Beschichtung auf der Oberfläche von anderen Materialien vorliegen können. Diese Metalle zeigen eine bessere Verträglichkeit mit den verwendeten niedrigschmelzenden Metalllegierungen, so dass sich der elektrische Kontakt verbessert. Insbesondere bevorzugt werden verkupferte oder vernickelte Aluminiumfasern, die neben ihrer hohen Leitfähigkeit und der durch die Oberflächenbeschichtung guten Verträglichkeit auch den Vorteil eines geringen Gewichts bieten. Solche Fasern werden zum Beispiel von IKI Global Inc, Korea, angeboten. Weiter bevorzugt werden kupfer- oder nickelbeschichtete Kohlenstofffasern, wie sie z. B. von Sulzer-Metco, Schweiz, unter dem Handelsnamen E-Fill angeboten werden.

Als faserförmig wird der Füllstoff dann angesehen, wenn das Aspektverhältnis, also das Verhältnis zwischen größter Längenausdehnung und dazu orthogonal stehender kleinster Längenausdehnung, mindestens 3, bevorzugt mindestens 10 beträgt.

Für ein dichtes und somit starres Netzwerk, welches der Verformung bei der hitzeaktivierten Verklebung einen hohen Widerstand entgegensetzt und somit das Aufbringen hoher Kontaktierungskräfte ermöglicht, wird eine Faserlänge zwischen 0,1 und 0,9 mm bevorzugt.

Für ein lockeres und somit elastisches Netzwerk, welches das Haftklebeband flexibel gestaltet und somit eine Verbesserung der Applizierbarkeit und der Anpassung an gekrümmte Untergründe ermöglicht, wird eine Länge der Faser im Bereich von 1 bis 10 mm bevorzugt.

Je nach Anwendung ist es auch vorteilhaft, ein Gemisch aus zumindest zwei elektrisch leitfähigen Füllstoffen einzusetzen, wobei zumindest einer der elektrisch leitfähigen Füllstoff faserförmig ist, aber auch zwei oder mehrere der elektrisch leitfähigen Füllstoffe, insbesondere alle elektrisch leitfähigen Füllstoffe faserförmig sein können.

Neben den beschriebenen Inhaltsstoffen können der HaftklebemassenZusammensetzung weitere Additive hinzugegeben werden, die die ihre Herstellung und/oder ihre Eigenschaften positive beeinflussen. Dies können beispielsweise, aber nicht abschließend, Dispergieradditive, Fließhilfsmitte, zum Beispiel Wachse oder Silikone, Verträglichkeitsverbesserer, Haftvermittler, Netzmittel, Lotflussmittel oder intrinsisch leitfähige Polymere sein.

Die Herstellung der Haftklebemassenzusammensetzung kann auf viele dem Fachmann geläufige Arten erfolgen. Bevorzug ist die Herstellung eines schmelzeförmigen Compounds aus Haftklebemasse, Füllstoff und Metalllegierung. Vorteilhafterweise wird das Compound bei einer Temperatur hergestellt und verarbeitet, bei der sowohl die niedrig schmelzende metallische Legierung als auch die Klebemasse in schmelzflüssigem Zustand vorliegen.

Um einen zu starken Anstieg der Viskosität zu verhindern können viskositätsabsenkende Zuschlagstoffe zugesetzt werden, zum Beispiel Wachse.

Die Herstellung des Kompounds kann sowohl diskontinuierlich zum Beispiel in einem Kneter als auch kontinuierlich zum Beispiel in einem Extruder, insbesondere vorteilhaft in einem Zweischneckenextruder oder einem kontinuierlichen Kneter, beispielsweise der Fa. Buss (PratteIn/Schweiz), erfolgen.

Die erfindungsgemäße Klebemassenzusammensetzung wird insbesondere als Klebeband eingesetzt. Im Folgenden werden unter dem Begriff Haftklebeband alle flächigen Haftklebeprodukte verstanden, unabhängig davon, ob die eine Dimension in der Fläche (x-Richtung) deutlich größer ist als die darauf senkrecht stehende Dimension in der Fläche (y-Richtung), also Klebebänder, Klebefolien, Klebebandabschnitte und dergleichen nach gängiger Begriffsverwendung.

Gegenstand der Erfindung ist daher ebenfalls ein Klebeband zumindest eine Schicht einer Haftklebemassenzusammensetzung, wie sie im Rahmen der Schrift beschrieben ist, insbesondere nach einem der Ansprüche.

Die erfindungsgemäßen Klebebänder können dabei
- einschichtig ausgebildet sein, also nur durch die Schicht der erfindungsgemäßen Haftklebemassenzusammensetzung gebildet werden (sogenannte "Transferklebebän der),
- sie können zweischichtig ausgebildet sein,
   -- etwa als einseitig klebendes Haftklebeband (Schicht der erfindungsgemäßen Haftklebemassenzusammensetzung auf einer weiteren, nichtklebenden Schicht, insbesondere einer Trägerschicht)
   -- oder als zweiseitig klebendes Haftklebeband (Schicht der erfindungsgemäßen Haftklebemassenzusammensetzung auf einer weiteren Haftklebemassenschicht),
- oder sie können drei- oder mehrschichtig sein,
   -- etwa als einseitig klebendes Haftklebeband (Schicht der erfindungsgemäßen Haftklebemassenzusammensetzung außenliegend auf weiteren, Schichten, wobei die zweite außenliegende Schicht nichtklebrig ist)
   -- oder als zweiseitig klebendes Klebeband mit zumindest einer innenliegenden Schicht, insbesondere einer Trägerschicht, und zwei außenliegenden Haftklebemassenschichten,
      --- von denen nur eine durch die erfindungsgemäße Haftklebemassenzusammensetzung gebildet ist,
      --- oder die beide durch die erfindungsgemäße Haftklebemassenzusammensetzung gebildet sind.

Die erfindungsgemäßen Haftklebemassen lassen sich hervorragend zur Herstellung eines elektrisch leitenden, insbesondere einschichtigen Flächenelements im Sinne des vorstehend beschriebenen Transferklebebandes einsetzen. Als Flächenelement im Sinne dieser Anmeldung gelten insbesondere alle üblichen und geeigneten Gebilde mit im Wesentlichen flächenförmiger Ausdehnung. Diese können verschieden ausgestaltet sein, insbesondere flexibel, als Folie, Band, Etikett, oder als Formstanzling.

Die Herstellung des Flächenelements aus dem insbesondere schmelzeförmigen Compound kann beispielsweise durch Ausstreichen, Beschichten, Extrudieren, Walzen, Pressen oder Verstrecken erfolgen.

Das Flächenelement kann eine Dicke aufweisen, wie sie im Bereich von einschichtigen Haftklebebändern üblich sind, also etwa zwischen 1 µm und 1000 µm. Bevorzugt ist eine Dicke von 10 bis 50 µm, wenn für die Anwendung die Leitfähigkeit innerhalb der Ebene des Flächenelements weniger bedeutsam ist. So kann Material eingespart werden und die Länge der vom Flächenelement leitfähig zu überbrückenden Distanz klein gehalten werden. Ist die Leitfähigkeit innerhalb der Ebene von hoher Bedeutung, ist eine Dicke des Flächenelements von 200 bis 500 µm bevorzugt, da hiermit eine größere Querschnittsfläche und somit eine höhere Leitfähigkeit geschaffen wird. Ein bevorzugter Kompromiss zwischen beiden Ausprägungen bildet eine Dicke von 50 bis 200 µm.

Weiterhin kann das Flächenelement einseitig oder beidseitig mit einem Trennliner eingedeckt sein.

In einer besonderen Ausführung kann das Flächenelement mit einer vollflächigen oder durchbrochenen elektrisch leitfähigen Schicht versehen sein. Diese Schicht kann auf zumindest einer Seite des Flächenelements angeordnet sein oder innerhalb des Flächenelements, so dass sich Haftklebstoff auf beiden Seiten der elektrisch leitfähigen Schicht befindet. Eine solche Schicht erhöht vorteilhaft die Leitfähigkeit des Flächenelements innerhalb der Ebene.

Als elektrisch leitende Schicht können alle üblichen und geeigneten Materialien verwendet werden, etwa Aluminium, Kupfer, Silber, Gold, Nickel, Mu-Metall, Alnico, Permalloy, Ferrit, Kohlenstoff-Nanoröhren, Graphen, intrinsisch leitende Polymere, Indium-Zinn-Oxid und dergleichen. Günstigerweise weist die elektrisch leitende Schicht dabei eine elektrische Leitfähigkeit von mehr als 20 MS/m auf (entsprechend einem spezifischen Widerstand von weniger als 50 mΩ·mm2/m), insbesondere von mehr als 40 MS/m (entsprechend einem spezifischen Widerstand von weniger als 25 mΩ·mm2/m), jeweils bestimmt für 300 K.

Die Schicht liegt vorteilhaft in durchbrochener Form vor, etwa als Stanzgitter, Drahtgeflecht, Streckmetall, Vlies oder als gedrucktes oder mit anderen üblichen Verfahren, auch mit Vakuumverfahren wie Bedampfen, abgeschiedenes Muster.

Die Form des haftklebrigen Flächenelements kann bahnförmig oder blattförmig sein. Insbesondere kann dabei die Form an die Geometrie der Verklebungsfläche angepasst sein, so dass der Klebemassenfilm etwa als Zuschnitt oder Stanzling vorliegt. Dies bedeutet insbesondere, dass die Form in etwa oder exakt der Form der Verbindungsflächen der zu verbindenden Bauteile und somit der lateralen Form der Klebefuge entspricht. Typischerweise sind bei solchen Flächenelementen die Anforderungen an Formstabilität und Verklebungsfestigkeit besonders hoch.

Für Anwendungen, in denen keine isotrope Leitfähigkeit gefordert wird, ist es vorteilhaft, die Fasern und/oder die durch die Metalllegierung gebildeten Bereiche (z.B. Partikel) entsprechend der gewünschten Vorzugsrichtung auszurichten. Dies kann zum Beispiel durch Verstreckung bei der Extrusion von erfindungsgemäßen haftklebrigen Flächenelementen erreicht werden. Hierdurch ergibt sich eine höhere Leitfähigkeit in der Ebene des haftklebrigen Flächenelementes. Bei der Verwendung magnetischer Fasern, zum Beispiel aus Nickel oder nickelbeschichteten Werkstoffen, ist es besonders vorteilhaft möglich, die Fasern mittels eines Magnetfeldes bei gleichzeitigem Aufheizen, auszurichten. Durch die erniedrigte Viskosität bei diesem Vorgang kann eine solche Ausrichtung erfolgen und wird nach dem Abkühlen festgehalten. Besonders vorteilhaft ist eine Aktivierung im Wesentlichen senkrecht zur Ebene des haftklebrigen Flächenelementes, da hierdurch eine verbesserte Kontaktierung der zu verklebenden Substrate erreicht wird. Die erforderlichen Magnete können dafür leicht in die Werkzeuge einer Klebepresse eingebracht werden. Besonders vorteilhaft ist für diese Verfahren die Verwendung von magnetisch beschichteten Kohlenstofffasern, da diese sich durch ihre hohe Steifigkeit leichter ausrichten lassen.

Gegenstand der Erfindung ist weiterhin ein Verfahren zum Verkleben eines Klebebandes, insbesondere eines haftklebrigen Flächenelements, auf einer Substratoberfläche, weiterhin ein Verfahren zum Verkleben zweier Substratoberflächen miteinander (die zwei unterschiedlichen Fügepartner zugeordnet sein können, aber auch zu einem einzigen Fügepartner mit entsprechend angeordneten zu verklebenden Flächen gehören können) mittels eines Klebebandes, insbesondere mittels eines haftklebrigen Flächenelements. Bei diesen Verfahren wird jeweils die Verklebung mittels einer solchen Schicht einer Klebemassenzusammensetzung bewirkt oder trägt zur Bewirkung der Verklebung maßgeblich eine solche Schicht einer Klebemassenzusammensetzung bei, die zumindest einen Polymer-Metall-Blend und zumindest einen faserförmigen elektrisch leitfähigen Füllstoff umfasst, wobei der Polymer-Metall-Blend seinerseits zumindest eine Haftklebemasse sowie zumindest eine im Temperaturbereich von 50 °C bis 400 °C schmelzende Metallkomponente umfasst, und wobei der Füllstoff zumindest teilweise in einem gebundenen Fasernetzwerk mit der Metallkomponente vorlegt. Die Metallkomponente ist dabei eine eutektische Metalllegierung enthaltend Zink, Zinn und/oder Wismut.

Die Haftklebemassenzusammensetzung ist dabei insbesondere eine solche, wie sie im Rahmen dieser Schrift beschrieben wurde und/oder wie er sich aus einem der Ansprüche ergibt.

Beim Fügen mittels der erfindungsgemäßen elektrisch leitfähigen Haftklebemasse unter Aufbringen einer Andruckkraft wird das Fasernetzwerk elastisch und/oder plastisch komprimiert und somit in innigen Kontakt zum Substrat gebracht. Im Gegensatz zu frei verteilt im Klebstoff vorliegenden leitfähigen Füllstoffen, die beim druckbehafteten Fügevorgang mit der viskoelastischen Haftklebermatrix fließen, wird das Netzwerk verformt und baut so einen Kontaktierungsdruck auf, der zu einer verbesserten und dauerhafteren Kontaktierung des Substrats führt.

Wie oben ausgeführt ist es nicht erforderlich, Haftklebemassen zur Bewirkung der Verklebung zu erwärmen. Von besonderem Vorteil ist es dennoch, wenn die erfindungsgemäße Haftklebemasse während oder nach der Applikation erwärmt wird. Dadurch kann die Haftklebemasse besser auffließen und somit steigt die Verklebungsfestigkeit. Die Temperatur sollte dabei bevorzugt mehr als 30 °C, weiter bevorzugt mehr als 50 °C betragen, um das Auffließen entsprechend zu fördern. Zu hoch sollte die Temperatur jedoch nicht gewählt werden, um das Fasernetzwerk nicht aufzuschmelzen. Die Temperatur sollte möglichst weniger als 120 °C betragen. Als optimaler Temperaturbereich haben sich Temperaturen zwischen 50 °C und 100 °C herausgestellt.

Die Applikationstemperatur kann aber auch oberhalb der Schmelztemperatur der niedrigschmelzenden Metalllegierung liegen. Überraschend wird durch die niedrigschmelzende Metallverbindung während der Applikation mit einer Temperatur oberhalb der Schmelztemperatur der Metallverbindung ein lotähnlicher Kontakt zum zu kontaktierten Substrat hergestellt, welcher den elektrischen Übergang im Vergleich zu lediglich berührenden Partikeln erheblich verbessert und zudem synergistisch zur Festigkeit der Verbindung beiträgt, so dass eine Festigkeit erreicht wird, die oberhalb der aufgrund der durchschnittlichen Benetzungsfläche der Haftklebemasse zu erwartenden Verklebungsfestigkeit liegt.

In einem weiteren vorteilhaften Verfahren wird zunächst ein Vorverbund des Flächenelements mit einem der Fügepartner bei einer Temperatur unterhalb der Schmelztemperatur der Metalllegierung gebildet. Hierdurch kann zum Beispiel ein vorgeformtes Flächenelement auf einem Fügeteil vorfixiert werden. Dann wir der andere Fügepartner mit der anderen Seite des Flächenelements in Kontakt gebracht. Aufgrund der haftklebrigen Eigenschaften ergibt sich sofort ein Verbund, so dass im günstigen Fall eine weitere Fixierung der Fügepartner nicht notwendig ist. In einer Weiterentwicklung dieses Verfahrens wird nach oder schon während dieser finalen Verklebung mit dem Fügepartner eine Temperatur oberhalb der Schmelztemperatur der Metalllegierung verwendet, so dass sich die synergistisch gesteigerte Festigkeit und erhöhte elektrische Leitfähigkeit der Verklebung einstellt.

Der erfindungsgemäße Artikel und die Verfahren wird bevorzugt zum Verkleben von Baueinheiten elektronischer Geräte eingesetzt, etwa solche aus dem Bereich der Konsumgüterelektronik, Unterhaltungselektronik oder Kommunikationselektronik (zum Beispiel für Mobiltelefone, PDAs, Laptops und andere Rechner, Digitalkameras und Anzeigegeräte wie etwa Displays, Digitalreader oder organische Leuchtdiodendisplays (OLEDs)) sowie für Solarzellenmodule wie etwa Siliziumsolarzellen, elektrochemische Farbstoff-Solarzellen, organische Solarzellen oder Dünnschichtzellen) oder elektrochemische Zellen, wie zum Beispiel Elektrolysezellen oder Brennstoffzellen. Als Baueinheiten werden vorliegend alle Bestandteile und Ansammlungen derselben verstanden, die in elektronischen Geräten verwendet werden, beispielsweise elektronische Bauteile (diskrete und integrierte Bauelemente), Gehäuseteile, elektronische Module, Antennen, Anzeigefelder, Schutzscheiben, unbestückte und/oder bestückte Platinen und dergleichen.

### Beispiele:

Die Bestimmung der Klebkraft erfindungsgemäßer haftklebriger Flächenelemente von 200 µm Massendicke erfolgte in einem Schälversuch unter einem Winkel von 180 ° bei einer Abzugsgeschwindigkeit von 300 mm/min nach ISO 29862:2007 (Methode 3). Alle Verklebungen, Lagerungen und Messungen wurden bei Raumtemperatur (23 °C) unter klimatisierten Bedingungen (bei 50 % relativer Luftfeuchtigkeit) durchgeführt. Der Schälversuch wurde an drei 20 mm breiten Mustern durchgeführt, wobei die Bestimmung der Klebkraft nach einer Verklebungzeit/Alterungsdauer von zwei Wochen erfolgte und hier der arithmetische Mittelwert angegeben wird.

Als Trägermaterial wurde eine 25 µm dicke, zur besseren Verankerung der Klebemasse an der Oberfläche angeätzte Polyesterfolie verwendet, wie sie von der Fa. Coveme (Italien) erhältlich ist. Als Haftgrund wurde ein gewalztes Messingblech von 3 mm Dicke verwendet, welches mit Aceton vor jeder Messung gereinigt wurde.

Zur Messung der elektrischen Leitfähigkeit wurden bei der Verklebung auf beiden Seiten des 200 µm dicken Haftklebemassefilms 50 µm dicke Messingfolien verwendet und runde Prüfkörper mit einer Fläche von 6,45 cm² mittels Lamination bei 23 °C angefertigt. Die Messung des Durchgangswiderstands erfolgte bei Raumtemperatur (23 °C) und 50 % relativer Luftfeuchte analog zu ASTM D 2739 mit einem Anpressdruck der Elektroden von 76 kPa. Angegeben ist der Mittelwert aus drei Messungen.

Abweichend wurde bei ausgewählten Beispielen die Verklebung bei einer erhöhten Applikationstemperatur in einem beheizten Rollenlaminator bei der jeweils angegebenen Temperatur erstellt. Die Prüfung der Muster fand jedoch immer bei den o.a. Bedingungen statt.

### Als Haftklebemassen wurden verwendet:

### Klebemasse 1:

Acrylat-Haftklebemasse die als Comonomere 30 Gew.-% Ethylhexylacrylat, 67 Gew.-% Butylacrylat, sowie 3 Gew.-% Acrylsäure enthielt.

Zur Herstellung der Acrylat-Haftklebemasse wurden die einzelnen Comonomere in dem Fachmann bekannter Weise in einem Gemisch aus Benzin und Aceton polymerisiert. Das Lösemittel wurde anschließend mittels eines Entgasungsextruders aus der entstandenen Acrylat-Polymermasse entfernt.

### Als faserförmige Füllstoffe wurden verwendet:

- Faser 1:: Kupferfaser F08 (0,8 mm lang, 60 µm dick) der Fa. Deutsches Metallfaserwerk, Neidenstein
- Faser 2:: Kupferfaser F3 (3 mm lang, 180 µm dick) der Fa. Deutsches Metallfaserwerk, Neidenstein

### Als niedrigschmelzende Metalllegierungen wurden verwendet:

- Metall 1:: MCP 200 (Schmelzpunkt 199 °C) der Fa. HEK, Lübeck
- Metall 2:: MCP 62 (Schmelzpunkt 60 °C) der Fa. HEK, Lübeck

### Folgende Compounds wurden hergestellt (Mengenangaben in Gew.-%):

| Beispiel | Haftklebemasse [Gew.-%] | Faser [Gew.-%] | | Metall [Gew.-%] | |
|---|---|---|---|---|---|
| | 1 | 1 | 2 | 1 | 2 |
| 1 | 40 | 20 | | 40 | |
| 2 | 20 | 20 | | 60 | |
| 3 | 25 | 35 | | 40 | |
| 4 | 5 | 35 | | 60 | |
| 5 | 32,5 | 27,5 | | 40 | |
| 6 | 12,5 | 27,5 | | 60 | |
| 7 | 30 | 20 | | 50 | |
| 8 | 15 | 35 | | 50 | |
| 9 | 22,5 | 27,5 | | 50 | |
| 10 | 15 | 33 | | 52 | |
| 11 | 15 | 40 | | 45 | |
| 12 | 15 | 45 | | 40 | |
| 13 | 15 | | 40 | 45 | |
| 14 | 15 | | 45 | 40 | |
| 15 | 15 | | 35 | 50 | |
| 16 | 15 | 40 | | | 45 |
| | | | | | |
| V1 | 15 | 85 | | | |
| V2 | 15 | | | 85 | |

Die Compounds wurden mit einem gleichläufigen Zweischneckenextruder ZSK25 der Fa. Coperion mit einem Verhältnis L/d von 40 hergestellt. Die Temperaturführung wurde jeweils so gewählt, dass Haftklebemasse und Metalllegierung vollständig aufgeschmolzen wurden. In einer ersten Verfahrenszone wurde ein Blend aus Haftklebemasse und Metalllegierung hergestellt, zu welchem in einer zweiten Verfahrenszone die Metallfasern hinzugegeben wurden. Zur Ausformung des erfindungsgemäßen Haftklebemassenfilms wurde direkt an den Extruder eine Flachfoliendüse angeflanscht und eine Flachfolie in der Dicke von 200 µm extrudiert.

Überraschenderweise stellte sich heraus, dass im Extrusionsverfahren wesentlich höhere Faseranteile verarbeitet werden konnten, als im Stand der Technik bekannt war.

Vergleichsbeispiel 1 wurde in einem Messkneter der Fa. Haake hergestellt, da sich die entsprechende Formulierung nicht mehr extrudieren ließ. Aus dem so hergestellten Compound wurden in einer Vakuumpresse der Fa. Laufer Presslinge mit einer Dicke von 200 µm hergestellt.

Die Verklebungsfestigkeiten sowie die elektrische Leitfähigkeiten sind in folgender Tabelle dargestellt:

| Beispiel | Applikationstemperatur [°C] | Klebkraft [N/cm] | Durchgangswiderstand [Ω·cm] | Bemerkungen |
|---|---|---|---|---|
| 1 | 23 | 3,1 | 1,92E-01 | |
| 2 | 23 | 1,9 | 1,41E-02 | |
| 3 | 23 | 2,0 | 1,40E-02 | |
| 4 | 23 | 1,2 | 4,16E-05 | |
| 5 | 23 | 2,7 | 6,14E-02 | |
| 6 | 23 | 1,5 | 1,71E-03 | |
| 7 | 23 | 2,6 | 6,16E-02 | |
| 8 | 23 | 1,9 | 1,70E-03 | |
| 9 | 23 | 2,2 | 1,40E-02 | |
| 10 | 23 | 1,9 | 2,02E-03 | |
| 11 | 23 | 2,0 | 1,07E-03 | |
| 12 | 23 | 2,0 | 6,44E-04 | |
| 13 | 23 | 1,9 | 8,10E-03 | |
| 14 | 23 | 2,2 | 1,01 E-02 | |
| 15 | 23 | 2,1 | 3,24E-03 | |
| 16 | 23 | 2,9 | 3,17E-03 | |
| 16a | 90 | > 6 | 1,22E-03 | Riss des Trägermaterials |

| Vergleichsbeispiel Beispiel | Applikationstemperatur [°C] | Klebkraft [N/cm] | Durchgangswiderstand [Ω·cm] | Bemerkungen |
|---|---|---|---|---|
| V1 | 23 | 2,2 | 1,36E0 | |
| V2 | 23 | 1,4 | 9,35E1 | |

Die Beispiele zeigen, dass die erfindungsgemäßen haftklebrigen Flächenelemente mit gebundenem Fasernetzwerk gegenüber den lediglich mit Fasern oder Partikeln gefüllten Vergleichsbeispielen deutlich erhöhte Leitfähigkeiten zeigen.

Eine Erhöhung des Faseranteils führt bei gleichbleibendem Gesamtfüllstoffgehalt in der Tendenz zu höheren Leitfähigkeiten und leicht erhöhten Verklebungsfestigkeiten, was auf die höhere Leitfähigkeit der Fasern und die größere Flexibilität des Netzwerks zurückgeführt wird.

Längere Fasern erniedrigen die Leitfähigkeit, was auf die höhere Orientierung in die Ebene des extrudierten Films zurückgeführt wird. Daraus ist auf eine Erhöhung der Leitfähigkeit in der Ebene zu schließen (Beispiele 13 - 15).

In den Beispielen 16 und 16a, bei denen die niedrigschmelzende Metalllegierung bei der Applikationstemperatur aufschmilzt, tritt der synergistische Effekt der gleichzeitigen Festigkeitserhöhung der Verklebung und Leitfähigkeitserhöhung auf. Dies wird auf eine verbesserte Kontaktierung des Substratmaterials zurückgeführt.

## Patentansprüche

1. Haftklebemassenzusammensetzung,
umfassend
a) einen Polymer-Metall-Blend umfassend
- zumindest eine Haftklebemasse,
- zumindest eine im Temperaturbereich von 50 °C bis 400 °C schmelzende Metallkomponente, nämlich eine eutektische Metalllegierung enthaltend Zink, Zinn und/oder Wismut.
b) zumindest einen faserförmigen elektrisch leitfähigen Füllstoff,
wobei der Füllstoff zumindest teilweise als gebundenes Fasernetzwerk mit der Metallkomponente vorliegt.

2. Haftklebemassenzusammensetzung nach einem der vorangehenden Ansprüche, **dadurch gekennzeichnet, dass**
die Haftklebemasse eine Polyacryklathaftklebemasse ist.

3. Haftklebemassenzusammensetzung nach Anspruch 1, **dadurch gekennzeichnet, dass** die Haftklebemasse eine Kautschukhaftklebemasse ist.

4. Haftklebemassenzusammensetzung nach einem der vorangehenden Ansprüche, **dadurch gekennzeichnet, dass**
zumindest einer der der elektrisch leitfähigen Füllstoffe metallisch ist.

5. Haftklebemassenzusammensetzung nach einem der vorangehenden Ansprüche, **dadurch gekennzeichnet, dass**
zumindest einer der elektrisch leitfähigen Füllstoffe eine Kohlenstoffmodifikation oder eine Kohlenstoff enthaltende chemische Verbindung ist.

6. Haftklebemassenzusammensetzung nach zumindest einem der vorangehenden Ansprüche, **dadurch gekennzeichnet, dass**
zumindest einer der elektrisch leitfähigen Füllstoffe magnetisch ist.

7. Haftklebemassenzusammensetzung nach zumindest einem der vorangehenden Ansprüche, **dadurch gekennzeichnet, dass**
die Haftklebemasse bei einer Schichtdicke von 50 µm eine Wasserdampfpermeation von weniger als 50 g/m²d bei 38 °C und 90 % relativer Feuchte aufweist, gemessen nach ASTM F-1249.

8. Haftklebemassenzusammensetzung nach zumindest einem der vorangehenden Ansprüche, **dadurch gekennzeichnet dass**
die Haftklebemasse einen Wassergehalt von weniger als 5000 ppm, insbesondere weniger als 1000 ppm aufweist, ermittelt nach 72 h Konditionierung bei 23 °C und 50 % relativer Feuchte mittels Karl-Fischer-Titration (Ausheiztemperatur 150 °C).

9. Haftklebeband, umfassend zumindest eine Schicht einer Haftklebemassenzusammensetzung nach einem der vorangehenden Ansprüche.

10. Haftklebeband nach Anspruch 9, weiterhin umfassend eine Schicht eines Trägermaterials, insbesondere eines elektrisch leitfähigen Trägermaterials.

11. Verfahren zum Verkleben auf einer Substratoberfläche, **dadurch gekennzeichnet, dass** die Verklebung mittels einer Haftklebemassenzusammensetzung nach einem der Ansprüche 1 bis 8 oder eines Haftklebebandes nach einem der Ansprüche 9 oder 10 bewirkt wird.

12. Verfahren nach Anspruch 11, **dadurch gekennzeichnet, dass**
zwei Substratoberflächen mittels einer Haftklebemassenzusammensetzung nach einem der Ansprüche 1 bis 8 oder eines Haftklebebandes nach einem der Ansprüche 9 oder 10 miteinander verklebt werden.

13. Verfahren nach einem der Ansprüche 11 oder 12, **dadurch gekennzeichnet, dass** die Verklebungsstelle während oder nach des Verklebungsvorganges mit einer Temperatur oberhalb der Schmelztemperatur der Metallkomponente beaufschlagt wird.

## Claims

1. Pressure-sensitive adhesive composition comprising
a) a polymer-metal blend comprising
- at least one pressure-sensitive adhesive,
- at least one metal component melting in the temperature range from 50°C to 400°C, specifically a eutectic metal alloy comprising zinc, tin and/or bismuth
b) at least one fibrous, electrically conductive filler,
the filler being present at least partly in the form of a bound fibre network with the metal component.

2. Pressure-sensitive adhesive composition according to any of the preceding claims, **characterized in that** the pressure-sensitive adhesive is a pressure-sensitive polyacrylate adhesive.

3. Pressure-sensitive adhesive composition according to Claim 1, **characterized in that** the pressure-sensitive adhesive is a pressure-sensitive rubber adhesive.

4. Pressure-sensitive adhesive composition according to any of the preceding claims, **characterized in that** at least one of the electrically conductive fillers is metallic.

5. Pressure-sensitive adhesive composition according to any of the preceding claims, **characterized in that** at least one of the electrically conductive fillers is a carbon modification or a carbon-containing chemical compound.

6. Pressure-sensitive adhesive composition according to at least one of the preceding claims, **characterized in that** at least one of the electrically conductive fillers is magnetic.

7. Pressure-sensitive adhesive composition according to at least one of the preceding claims, **characterized in that** at a layer thickness of 50 µm pressure-sensitive adhesive has a water vapour permeation of less than 50 g/m²d at 38°C and 90% relative humidity, measured in accordance with ASTM F-1249.

8. Pressure-sensitive adhesive composition according to at least one of the preceding claims, **characterized in that** the pressure-sensitive adhesive has a water content of less than 5000 ppm, more particularly less than 1000 ppm, determined after 72 h of conditioning at 23°C and 50% relative humidity by means of Karl Fischer titration (heating temperature 150°C).

9. Pressure-sensitive adhesive tape comprising at least one layer of a pressure-sensitive adhesive composition according to any of the preceding claims.

10. Pressure-sensitive adhesive tape according to Claim 9, further comprising a layer of a carrier material, more particularly of an electrically conductive carrier material.

11. Method for adhesive bonding on a substrate surface, **characterized in that** the bonding is produced by means of a pressure-sensitive adhesive composition according to any of Claims 1 to 8 or of a pressure-sensitive adhesive tape according to either of Claims 9 and 10.

12. Method according to Claim 11, **characterized in that** two substrate surfaces are bonded to one another by means of a pressure-sensitive adhesive composition according to any of Claims 1 to 8 or of a pressure-sensitive adhesive tape according to either of Claims 9 and 10.

13. Method according to either of Claims 11 and 12, **characterized in that** the bond site, during or after the bonding operation, is subjected to a temperature above the melting temperature of the metal component.

## Revendications

1. Composition de matière adhésive de contact, comprenant :
a) un mélange polymère-métal comprenant :
- au moins une masse adhésive de contact,
- au moins un composant métallique fondant dans la plage de température allant de 50 °C à 400 °C, à savoir un alliage métallique eutectique contenant du zinc, de l'étain et/ou du bismuth,
b) au moins une charge fibreuse électriquement conductrice,
la charge se présentant au moins partiellement sous la forme d'un réseau de fibres lié avec le composant métallique.

2. Composition de matière adhésive de contact selon l'une quelconque des revendications précédentes, **caractérisée en ce que** la matière adhésive de contact est une matière adhésive de contact à base de polyacrylate.

3. Composition de matière adhésive de contact selon la revendication 1, **caractérisée en ce que** la matière adhésive de contact est une matière adhésive de contact à base de caoutchouc.

4. Composition de matière adhésive de contact selon l'une quelconque des revendications précédentes, **caractérisée en ce qu'**au moins une des charges électriquement conductrices est métallique.

5. Composition de matière adhésive de contact selon l'une quelconque des revendications précédentes, **caractérisée en ce qu'**au moins une des charges électriquement conductrices est une forme de carbone ou un composé chimique contenant du carbone.

6. Composition de matière adhésive de contact selon au moins l'une quelconque des revendications précédentes, **caractérisée en ce qu'**au moins une des charges électriquement conductrices est magnétique.

7. Composition de matière adhésive de contact selon au moins l'une quelconque des revendications précédentes, **caractérisée en ce que** la matière adhésive de contact présente à une épaisseur de couche de 50 µm une perméation de la vapeur d'eau de moins de 50 g/m²j à 38 °C et 90 % d'humidité relative, mesurée selon ASTM F-1249.

8. Composition de matière adhésive de contact selon au moins l'une quelconque des revendications précédentes, **caractérisée en ce que** la matière adhésive de contact présente une teneur en eau de moins de 5 000 ppm, notamment de moins de 1 000 ppm, déterminée après 72 h de conditionnement à 23 °C et 50 % d'humidité relative par titrage de Karl-Fischer (température de chauffage 150 °C).

9. Bande adhésive de contact, comprenant au moins une couche d'une composition de matière adhésive de contact selon l'une quelconque des revendications précédentes.

10. Bande adhésive de contact selon la revendication 9, comprenant en outre une couche d'un matériau support, notamment d'un matériau support électriquement conducteur.

11. Procédé de collage sur une surface de substrat, **caractérisé en ce que** le collage est réalisé au moyen d'une composition de matière adhésive de contact selon l'une quelconque des revendications 1 à 8 ou d'une bande adhésive de contact selon l'une quelconque des revendications 9 ou 10.

12. Procédé selon la revendication 11, **caractérisé en ce que** deux surfaces de substrat sont collées l'une avec l'autre au moyen d'une composition de matière adhésive de contact selon l'une quelconque des revendications 1 à 8 ou d'une bande adhésive de contact selon l'une quelconque des revendications 9 ou 10.

13. Procédé selon l'une quelconque des revendications 11 ou 12, **caractérisé en ce que** l'emplacement de collage est exposé à une température supérieure à la température de fusion du composant métallique pendant ou après le processus de collage.
